# EUROPÄISCHE PATENTSCHRIFT

(11) **EP 3 531 157 B1**
(45) Veröffentlichungstag und Bekanntmachung des Hinweises auf die Patenterteilung: **10.04.2024**
(21) Anmeldenummer: 18158887.2
(22) Anmeldetag: 27.02.2018
(51) Int. Cl.: G01R 33/3815, H01F 6/00, H05K 7/20

(54) **MAGNETRESONANZEINRICHTUNG MIT GEMEINSAMER KÜHLEINRICHTUNG FÜR MEHRERE ELEKTRONIKKOMPONENTEN UND VERFAHREN ZUM HERSTELLEN EINER SOLCHEN MAGNETRESONANZEINRICHTUNG**
MAGNETIC RESONANCE DEVICE COMPRISING A SHARED COOLING UNIT FOR MULTIPLE ELECTRONIC COMPONENTS AND METHOD FOR PRODUCING SUCH A MAGNETIC RESONANCE DEVICE
DISPOSITIF DE RÉSONANCE MAGNÉTIQUE COMPRENANT UN DISPOSITIF DE REFROIDISSEMENT PARTAGÉ POUR PLUSIEURS MODULES ÉLECTRONIQUES ET PROCÉDÉ DE FABRICATION D'UN TEL DISPOSITIF DE RÉSONANCE MAGNÉTIQUE

(43) Veröffentlichungstag der Anmeldung: 28.08.2019
(73) Patentinhaber: Siemens Healthineers AG, 91301 Forchheim (DE)
(72) Erfinder: Biber, Stephan, 91056 Erlangen (DE)
(74) Vertreter: Siemens Healthineers Patent Attorneys

(56) Entgegenhaltungen:
- CN-U- 204 305 549
- DE-A1- 19 527 150
- DE-A1-102016 208 107
- US-A1- 2015 062 819

## Beschreibung

Die Erfindung betrifft eine Magnetresonanzeinrichtung, aufweisend eine Hauptmagneteinheit mit einem eine supraleitende Spule umfassenden Hauptmagneten zur Erzeugung eines Grundmagnetfelds, eine zum Herunterfahren und Herauffahren des Hauptmagneten ausgebildete Rampvorrichtung mit einer an der Hauptmagneteinheit angeordneten, bei einem Herauffahrvorgang und/oder einem Herunterfahrvorgang Wärme abgebenden Rampkomponente, insbesondere einer Leistungsversorgungseinheit für den Hauptmagneten und/oder einer Herunterfahrlasteinheit mit einer beim Herunterfahren genutzten elektrischen Last, eine Kühleinrichtung und wenigstens eine zu kühlende Elektronikbaueinheit. Daneben betrifft die Erfindung ein Verfahren zum Herstellen einer solchen Magnetresonanzeinrichtung.

Magnetresonanzeinrichtungen werden heute häufig im klinischen Umfeld zur diagnostischen Bildgebung sowie anderweitig zur Materialprüfung eingesetzt. Dabei wird ein Grundmagnetfeld durch einen in einer meist zylindrischen Hauptmagneteinheit verbauten Hauptmagneten, der eine supraleitende Spule umfasst, bereitgestellt. Zur Kühlung der Supraleiter weist eine derartige Hauptmagneteinheit üblicherweise auch ein Kühlsystem auf, welches beispielsweise mittels Helium als Kühlmittel betrieben wird.

Doch auch weitere Komponenten einer Magnetresonanzeinrichtung benötigen Kühlung, insbesondere Elektronikbaueinheiten, die beispielsweise in Form von Leistungsverstärkern auch Leistungselektronikkomponenten aufweisen können. Beispielhaft zu nennen sind hier eine Sendeeinheit, eine Empfangseinheit und eine Sequenzsteuereinheit. Dabei sind die entsprechenden Kühleinrichtungen, die häufig Wasser als Kühlmittel nutzen, bei heute bekannten Magnetresonanzeinrichtungen meist weniger effektiv ausgebildet, nachdem die Kühlleistung über weite Wege verteilt wird und oft mit wenig Effizienz an zu kühlende Komponenten der Magnetresonanzeinrichtung herangeführt wird.

So ist es beispielsweise für Sendeeinheiten und Empfangseinheiten an der Hauptmagneteinheit bekannt, eine Wasserkühlung zu verwenden. Für die Sendeeinheit werden beispielsweise Endstufen direkt wassergekühlt, während es für die Empfangseinheit und ihre Elektronikbauteile sowie die Kleinsignalelektronikbauteile der Sendeeinheit bekannt ist, in einem Luft-Wasser-Wärmetauscher kaltes Wasser zu erzeugen, dass dann in entsprechenden die Elektronikbauteile enthaltenen Gehäusen beispielsweise unter Verwendung von Ventilatoren zwangszirkuliert wird. Die damit verbundenen Infrastrukturkosten und der Platzbedarf sind äußerst hoch.

In anderen Ausführungsformen des Standes der Technik ist es bekannt, Elektronikbaueinheiten unmittelbar mit einem eigenen Kühler zu versehen, der dann Teil der entsprechenden Elektronikbaugruppe ist. Hierdurch werden die Kosten erhöht, nachdem das Material komplexer verbaut wird und Overhead durch alle Logistikketten zustande kommen. Ein weiterer Nachteil ist, dass die Kühlung mit solchen Kühlern nur für eine einzige Baugruppe beziehungsweise Elektronikbaueinheit möglich ist.

Diese Probleme werden bei neueren Magnetresonanzeinrichtungen, insbesondere solchen, die nur eine geringe Heliummenge als Kühlmittel des Kühlsystems der Hauptmagneteinheit nutzen, beispielsweise weniger als 10 Liter, noch deutlicher, nachdem dort vorgeschlagen wurde, eine die Leistungsversorgungseinheit der entsprechenden Magnetresonanzeinrichtung, die die Leistung für den Hauptmagneten bereitstellt, nutzende Rampvorrichtung vorzusehen, die ausgebildet ist, den Hauptmagneten (mithin den Stromfluss in der supraleitenden Spule) hoch- und herunterzufahren ("hochrampen" beziehungsweise "herunterrampen"). So können, beispielsweise für eine Servicemaßnahme beziehungsweise einen erforderlichen Neustart des Hauptmagneten vor Ort, einfach umsetzbare Möglichkeiten bereitgestellt werden, um den Hauptmagneten schnell herunter- und wieder herauffahren zu können. Zum Herunterfahren des Hauptmagneten ist eine Last, die so genannte Herunterfahrlast ("Run Down Load") erforderlich, die in einer Herunterfahrlasteinheit bereitgestellt werden kann. Beispielsweise offenbart DE 10 2016 081 107 A1 eine Magnetresonanzanlage mit einer solchen Leistungsversorgungseinheit, die an der Hauptmagneteinheit selbst befestigt ist und angesteuert werden kann, den Strom durch die supraleitende Spule des Hauptmagneten herunterzufahren.

Bei solchen Ausgestaltungen entsteht die Anforderung, auch die Herunterfahrlast sowie die Leistungsversorgungseinheit an der Hauptmagneteinheit zu kühlen. Dabei entstehen gerade im Hinblick auf die Herunterfahrlast hohe Kühlanforderungen, nachdem dort beispielsweise Leistungen von bis zu 3 kW umgesetzt werden.

DE 10 2016 208 107 A1 betrifft eine Magnetresonanzanlage und ein Verfahren zur Ansteuerung einer Leistungsversorgungseinheit für eine supraleitende Spule. Darin wird vorgeschlagen, eine Magnetresonanzeinrichtung mit einer durch wenigstens eine Steuereinrichtung der Magnetresonanzanlage ansteuerbaren Leistungsversorgungseinheit zu versehen, die an der Hauptmagneteinheit angeordnet, insbesondere befestigt, oder in diese integriert ist. Die Leistungsversorgungseinheit kann zum Hoch- und Herunterfahren des Stromes durch die supraleitende Spule ausgebildet sein und passive Kühlkomponenten aufweisen.

DE 195 27 150 A1 betrifft ein Magnetresonanzgerät mit einer supraleitenden Spulenanordnung. Das Magnetresonanzgerät umfasst eine Magnetstromversorgung zum Auf- oder Abmagnetisieren der Spulenanordnung und eine Gradientenstromversorgung für Gradientenspulen. Die Gradientenstromversorgung ist über eine Umschalteinrichtung mit der Magnetstromversorgung und mindestens einer Gradientenspule verbunden, so dass ein wahlweises elektrisches Verbinden der Gradientenstromversorgung mit der Magnetstromversorgung oder der Gradientenspule möglich ist.

US 2015/0062819 A1 betrifft Verfahren und Vorrichtungen, die Wärmerohre zur Verbindung elektronischer Anordnungen, die ungleich Wärme produzieren, offenbart. Für unterbrechungsfreie Stromversorgungen wird dort vorgeschlagen, erste und zweite Befestigungsstellen von Elektronikanordnungen auf einer Wärmesenke mittels eines Wärmerohrs zu verbinden.

CN 204305549 U offenbart eine Ladeeinrichtung für ein Kraftfahrzeug, bei der ein Ladegerät und ein Gleichspannungswandler, die nicht gleichzeitig arbeiten können, beide auf einer gemeinsamen Wärmesenke angeordnet sein sollen.Der Erfindung liegt daher die Aufgabe zugrunde, eine dem gegenüber vereinfachte, effiziente Umsetzung einer Kühleinrichtung für außerhalb der Hauptmagneteinheit gelegene Komponenten einer Magnetresonanzeinrichtung anzugeben, die insbesondere auch eine vereinfachte Herstellung der Magnetresonanzeinrichtung erlaubt.

Zur Lösung dieser Aufgabe sind bei einer Magnetresonanzeinrichtung der eingangs genannten Art erfindungsgemäß die Merkmale des Anspruchs 1 vorgesehen. Die Kühleinrichtung weist dabei eine an der Rampkomponente befestigte und mit dieser in wärmeleitendem Kontakt stehende Kühlplatte auf, an die bezüglich der Hauptmagneteinheit nach außen in wärmeleitendem Kontakt eine Trägerplatte anschließt, die wenigstens eine Elektronikbaueinheit in wärmeleitendem Kontakt trägt.

Das bedeutet, die Kühlplatte ist sowohl zur Kühlung der Rampkomponente, insbesondere der Herunterfahrlasteinheit, als auch zur indirekten Kühlung der wenigstens einen Elektronikbaueinheit ausgebildet, nachdem die Trägerplatte nicht nur als tragendes Bauteil für die wenigstens eine Elektronikbaueinheit wirkt, sondern auch als Wärmeübertrager von der Elektronikbaueinheit an die Kühlplatte beziehungsweise als Kühlverteiler an die insbesondere mehreren Elektronikbaueinheiten wirkt. Die fest an der Hauptmagneteinheit verbaute Rampkomponente wird mit einer Kühlplatte versehen, die bevorzugt mittels eines in der Kühleinrichtung zirkulierenden Kühlmittels, insbesondere von diesem durchströmt, kühlbar ist. Dabei wird als Kühlmittel bevorzugt Wasser verwendet. Beispielsweise kann die Kühlplatte mithin an einen entsprechenden Kühlmittelkreislauf angeschlossene Kühlkanäle aufweisen, die es erlauben, eine hinreichend hohe Kühlleistung für den Fall eines Hochfahrens bzw. Herunterfahrens des Stromflusses in der supraleitenden Spule des Hauptmagneten bereitzustellen, da dann eine deutliche Erwärmung der insbesondere als Leistungsversorgungseinheit und/oder Herunterfahrlast ausgebildeten Rampkomponente auftritt, die thermisch an die Kühlplatte gekoppelt ist. Bevorzugt ist die Kühlplatte dabei über einen wärmeleitfähigen Klebstoff und/oder mechanische Befestigungsmittel unmittelbar an der Rampkomponente befestigt. Die Rampvorrichtung kann als eine entsprechend ausgebildete Leistungsversorgungseinrichtung der Magnetresonanzeinrichtung verstanden werden.

Viele Elektronikbaueinheiten, die der Kühlung bedürfen, müssen ohnehin an der Hauptmagneteinheit befestigt werden, so dass die vorliegende Erfindung eine gemeinsame Trägerplatte für diese Elektronikbaueinheiten vorschlägt, was die Zahl der mechanischen Schnittstellen, beispielsweise Schweißnähten an der Hauptmagneteinheit, reduziert, Kosten einspart und insbesondere auch eine Vorfertigung der Trägerplatte mit der wenigstens einen, insbesondere mehreren Elektronikbaueinheiten erlaubt.

Die Trägerplatte wird thermisch mit der Kühlplatte der Rampkomponente verbunden, wobei die Trägerplatte, insbesondere zum Tragen mehrerer Elektronikbaueinheiten, deutlich größer als die Kühlplatte ausgebildet sein kann.

Während es konkret vorgesehen sein kann, dass die Trägerplatte, insbesondere über Befestigungsstutzen, an der insbesondere zylindrischen Hauptmagneteinheit befestigt ist, sieht eine bevorzugte Ausgestaltung der vorliegenden Erfindung alternativ oder zusätzlich vor, dass die Kühlplatte die an ihr befestigte Trägerplatte mit der wenigstens einen Elektronikbaueinheit trägt. Das bedeutet, über die thermische Anbindung der Trägerplatte an die Kühlplatte hinaus kann auch eine mechanische Verbindung zwischen der Trägerplatte und der Kühlplatte vorgesehen sein, beispielsweise durch Verwendung eines wärmeleitfähigen Klebstoffs und/oder mechanischer Befestigungsmittel, beispielsweise von Schrauben oder dergleichen. Insbesondere auf der der Kühlplatte abgewandten Seite der Trägerplatte werden dann die Elektronikbaueinheiten angeordnet, so dass die Trägerplatte, wie beschrieben, zwei Funktionen gleichzeitig erfüllen kann, nämlich als Trägerteil zur Vereinfachung der Montage und gleichzeitig als Verteiler von Kühlleistung wirken kann. Ist die Kühlplatte an der Rampkomponente, insbesondere der Herunterfahrlasteinheit, befestigt, kann die Gewichtskraft über diese abgeführt werden, was es ganz ohne weitere Montagepunkte an der Hauptmagneteinheit erlaubt, die Kühlkomponenten sowie die Elektronikbaueinheiten zu befestigen.

Während es grundsätzlich vorgesehen sein kann, die hier angesprochenen Komponenten an einer Seite der Hauptmagneteinheit, bei einer zylindrischen Ausbildung mithin an der Zylinderfläche, anzuordnen, wird es bevorzugt, wenigstens die Rampkomponente, ggf. die Kühlplatte, die Trägerplatte und die Elektronikbaueinheiten tragend, insbesondere jedoch auch die Kühlplatte und/oder die Trägerplatte, an einer Endseite, insbesondere Stirnseite, der länglichen und/oder zumindest im Wesentlichen zylindrischen Hauptmagneteinheit zu befestigen. Bei einer länglichen und/oder zylindrischen Ausgestaltung der Hauptmagneteinheit, insbesondere mit einer zylindrischen Patientenaufnahme, bietet sich hierbei eine Befestigung an den Stirnseiten des Vakuumgefäßes, in dem der Hauptmagnet angeordnet ist, an. Das Vakuumgefäß ist meist ohnehin so konstruiert, dass die Stirnseiten die hohen Vertikalkräfte der Gradientenspulenanordnung aufnehmen sollen, so dass die weiteren Komponenten nicht mehr ins Gewicht fallen. Die insbesondere im Wesentlichen als Zylindermantelfläche ausgeformten Seiten des Vakuumgefäßes müssen dann lediglich dem Vakuum standhalten.

Insbesondere bei einer, wenn auch weniger bevorzugten, Anbringen an einer gekrümmten Seitenfläche der Hauptmagneteinheit kann die Trägerplatte der Form der Seitenfläche folgend, mithin an die Hauptmagneteinheit angeformt, ausgebildet sein. Auch eine geknickte Ausgestaltung ist zur Anformung denkbar.

Die Trägerplatte erlaubt es mithin, einen großen Teil der Wärmeleistung der Elektronik abzuführen, ohne dass Ventilatoren und/oder andere komplexe Komponenten benötigt werden oder Elektronikbauteile bei passiver Kühlung eventuell zu warm werden. Dabei sei angemerkt, dass bei einer Herunterfahrlasteinheit als Rampkomponente die Kühlleistung, die die Kühlplatte abgeben muss, primär durch die Herunterfahrlast bestimmt ist. Wird die Herunterfahrlast eingesetzt, sind andere Elektronikbaueinheiten, beispielsweise Sendeeinheiten und dergleichen, inaktiv, so dass sich die benötigten Kühlleistungen nicht addieren. Während an der Herunterfahrlasteinheit Kühlleistungen von beispielsweise bis zu 3 kW anfallen können, benötigen Elektronikbaueinheiten anderer Art der Magnetresonanzeinrichtung meist nur 20 bis 200 W, so dass Verluste der Kühlleistung durch die Wärmeleitung der Trägerplatte weniger relevant sind, da die vorhandene Kühlleistung ohnehin viel höher ausgelegt werden muss als das von der wenigstens einen Elektronikbaueinheit benötigte. Vergleichbares gilt für die Leistungsversorgungseinheit (auch als Hochfahreinheit bezeichenbar) als Rampkomponente. Die Leistungsversorgungseinheit kann insbesondere ein Netzteil umfassen.

Dabei sei angemerkt, dass die insbesondere groß, mithin größer als die Kühlplatte, ausgebildete Trägerplatte auch Kälte abstrahlt und in der Lage ist, warme Luft, die sich eventuell unter einer Außenabdeckung der Magnetresonanzeinrichtung aufstaut, zu kühlen. Zu einer solchen Erzeugung von warmer Luft kann es beispielsweise kommen, wenn Elektronikbauteile der wenigstens einen Elektronikbaueinheit nicht ihre gesamte Wärme über die Trägerplatte abführen.

Zusammenfassend schlägt die Erfindung mithin die doppelte Nutzung einer Trägerplatte zum einen zur mechanischen Halterung wenigstens einer Elektronikbaueinheit, zum anderen zur Leitung von Kühlleistung zu den Elektronikbauteilen, vor. Insbesondere wirkt die Trägerplatte bei mehreren Elektronikbaueinheiten als Verteiler der Kühlleistung für derartige Elektronikkomponenten unterschiedlichster Funktion. Es resultiert eine vereinfachte Fertigung hinsichtlich der Kühleinrichtung und der Elektronikbaueinheiten, die an der Hauptmagneteinheit zu befestigen sind. Durch die Mitnutzung der Kühlplatte für die Rampkomponente ist eine effiziente Kühlung ohne signifikanten Mehraufwand (keine eigene Kühlung für einzelne Elektronikbaueinheiten) und ohne wartungsanfällige Komponenten, beispielsweise Ventilatoren, möglich. In diesem Kontext wurde erkannt, dass die Rampkomponente und die Elektronikkomponenten keiner gleichzeitigen Maximalkühlung bedürfen, so dass die multiple Anwendung der Kühlplatte ermöglicht wird.

Es sei an dieser Stelle noch angemerkt, dass es durchaus auch denkbar ist, mehrere Trägerplatten zu verwenden, die entsprechend wärmeleitend mit der Kühlplatte zu verbinden sind. Bevorzugt ist jedoch die Verwendung einer einzigen Trägerplatte. Die Trägerplatte kann allgemein bevorzugt aus Aluminium bestehen, da dieses Material eine hinreichende Wärmeleitfähigkeit bei insgesamt gewichtsarmer Ausgestaltung der Trägerplatte erlaubt. Auch andere Materialien für die Trägerplatte sind grundsätzlich denkbar, beispielsweise bei gewünschter besserer Wärmeleitfähigkeit Kupfer.

In einer vorteilhaften Weiterbildung der vorliegenden Erfindung kann vorgesehen sein, dass die Trägerplatte wenigstens eine wärmeführende Struktur, insbesondere eine Dickenveränderung und/oder wenigstens eine Kühlrippe, aufweist. Derartige, im Stand der Technik grundsätzlich bekannte wärmeleitende Strukturen, insbesondere eine Variation der Dicke und/oder eine Verwendung von Rippen, erlaubt mit besonderem Vorteil eine gezielte Führung von Wärme und somit der Kühlleistung innerhalb der Trägerplatte. So sieht eine Weiterbildung vor, dass die wenigstens eine wärmeführende Struktur einen Wärmeführungsweg von wenigstens einer der wenigstens einen Elektronikbaueinheit zu der Kühlplatte definiert. Auf diese Weise können Kühlverluste durch zu starke Kälteabgabe entfernt von Elektronikbaueinheiten möglichst weitgehend vermieden werden. Insbesondere ergibt sich in diesem Zusammenhang die vorteilhafte Ausgestaltung, dass für unterschiedliche Elektronikbaueinheiten wenigstens teilweise eine unterschiedliche Wärmeleitfähigkeit aufweisende Wärmeführungswege in der Trägerplatte vorgesehen sind, insbesondere in Abhängigkeit ihres Kühlbedarfs. Das bedeutet, Wärmeführungswege geringerer Wärmeleitfähigkeit können zu einen geringeren Kühlbedarf aufweisenden Elektronikbaueinheiten geführt werden, während Wärmeführungswege größer Wärmeleitfähigkeit zu Elektronikbaueinheiten größeren Kühlbedarfs geführt werden können, um eine adäquate Kühlung aller Elektronikbaueinheiten sicherzustellen. Auf diese Art und Weise wird die Effizienz der Kühlung insgesamt weiter verbessert.

In diesem Kontext kann es auch zweckmäßig sein, wenn eine die Kühleinrichtung steuernde Kühlsteuereinheit zur Bereitstellung einer größeren Kühlleistung an die Kühlplatte bei einem Herunterfahren und/oder Hochfahren des Hauptmagneten ausgebildet ist. Wie bereits erwähnt wurde, werden besonders hohe Kühlleistungen bei einer Erwärmung der Herunterfahrlast der Herunterfahrlasteinheit aufgrund eines Herunterfahrens des Stromflusses innerhalb der supraleitenden Spule benötigt. Mithin kann, falls entsprechende Steuerkomponenten, beispielsweise Pumpen, vorliegen, die Kühlleistung an eine aktuelle Situation und einen aktuellen Kühlbedarf der zu kühlenden Komponenten der Magnetresonanzeinrichtung angepasst werden. Vergleichbares gilt für das Hochfahren bei der Leistungsversorgungseinheit als Rampkomponente.

Neben der Magnetresonanzeinrichtung betrifft die Erfindung auch ein Verfahren zum Herstellen einer Magnetresonanzeinrichtung der erfindungsgemäßen Art, umfassend folgende Schritte:
- an einem ersten Herstellungsort, Anbringen der Rampkomponente, insbesondere der Herunterfahrlasteinheit, an der Hauptmagneteinheit,
- an einem zweiten Herstellungsort, Anbringen der Kühlplatte in wärmeleitendem Kontakt an der Rampkomponente, Anbringen der Trägerplatte in wärmeleitendem Kontakt an der Kühlplatte, und Anbringen der wenigstens einen Elektronikbaueinheit in wärmeleitendem Kontakt an der Trägerplatte.

Wie bereits erwähnt, bietet die Ausbildung der erfindungsgemäßen Magnetresonanzeinrichtung besondere Vorteile bei der Herstellung der Magnetresonanzeinrichtung, da insbesondere bei der Realisierung der mechanischen Verbindungen von der Hauptmagneteinheit her direkt als Hauptmagneteinheit - Rampkomponente, Rampkomponente - Kühlplatte, Kühlplatte - Trägerplatte, Trägerplatte - Elektronikbaueinheit nur die Rampkomponente selbst unmittelbar an der Hauptmagneteinheit zu befestigen ist. Gerade dann, wenn, wie im erfindungsgemäßen Verfahren vorgesehen, die Hauptmagneteinheit bereits mit angebrachter Rampkomponente, insbesondere Herunterfahrlasteinheit, hergestellt und an einem zweiten Herstellungsort bereitgestellt wird, ergibt sich mithin eine besonders einfache Anbringung und Wartung der nach außen nachfolgenden Komponenten außerhalb der Fertigung des Hauptmagneten.

In einer besonders vorteilhaften Weiterbildung des erfindungsgemäßen Verfahrens kann vorgesehen sein, dass an dem zweiten Herstellungsort zunächst die wenigstens eine Elektronikbaueinheit in wärmeleitendem Kontakt an der Trägerplatte angebracht wird, so dass eine vorgefertigte Baueinheit entsteht, die dann insgesamt, insbesondere an der Kühlplatte, angebracht werden kann. Dies stellt eine weitere, deutliche Vereinfachung im Herstellungsprozess dar, nachdem die Montage der Elektronikbaueinheiten noch entfernt von der Hauptmagneteinheit in einem Vorfertigungsschritt erfolgen kann.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: einen für die vorliegende Erfindung relevante Komponenten zeigenden Querschnitt einer erfindungsgemäßen Magnetresonanzeinrichtung,
- Fig. 2: eine für die vorliegende Erfindung relevante Komponenten zeigende seitliche Aufsicht auf eine erfindungsgemäße Magnetresonanzeinrichtung,
- Fig. 3: eine Prinzipskizze zur Herstellung der erfindungsgemäßen Magnetresonanzeinrichtung,
- Fig. 4: einen Fig. 1 entsprechenden Querschnitt für ein zweites Ausführungsbeispiel einer erfindungsgemäßen Magnetresonanzeinrichtung, und
- Fig. 5: einen Fig. 2 entsprechende Stirnseitenaufsicht auf das zweite Ausführungsbeispiel.

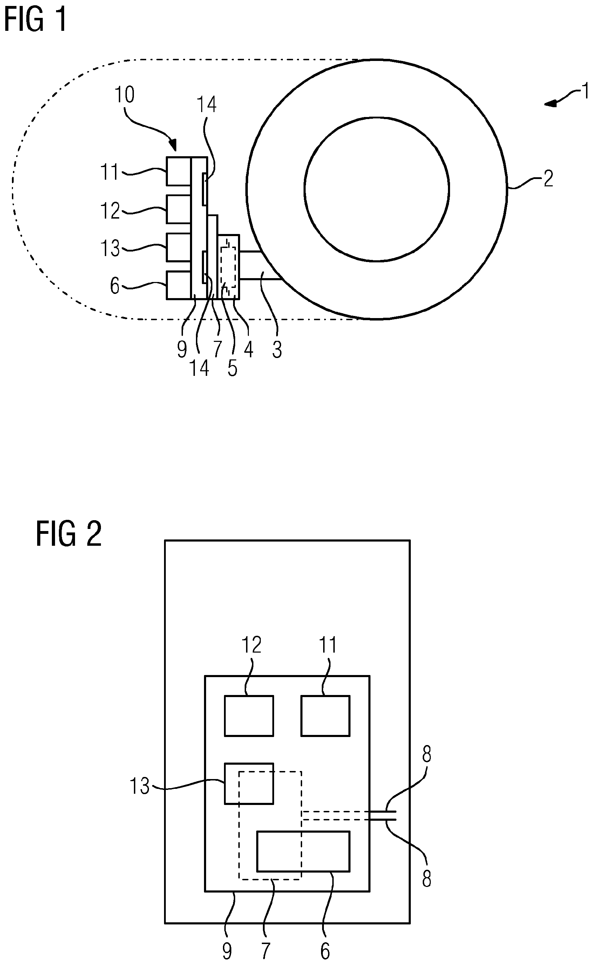

Fig. 1 zeigt eine prinzipielle Querschnittsansicht eines Ausführungsbeispiels einer erfindungsgemäßen Magnetresonanzeinrichtung 1. Diese weist eine im Wesentlichen zylindrische Hauptmagneteinheit 2 auf, die als Hauptmagneten eine supraleitende Spule und ein Kühlsystem für die supraleitende Spule umfasst. Diese Komponenten sind der Einfachheit halber nicht näher dargestellt. Die im Kühlsystem der Hauptmagneteinheit 2 benötigte und somit vorgesehene Heliummenge ist dabei vorliegend kleiner als 10 Liter.

Außen an der Hauptmagneteinheit 2 ist über entsprechende Befestigungsmittel 3, beispielsweise Befestigungsstutzen, eine Herunterfahrlasteinheit 4 als Rampkomponente befestigt, die eine hier nur angedeutete Herunterfahrlast 5 umfasst. Die Herunterfahrlast 5 wird genutzt, wenn der Stromfluss in der supraleitenden Spule heruntergefahren werden soll, mithin ein Herunterfahren des Hauptmagneten durch eine entsprechend ausgebildete Leistungsversorgungseinheit 6 für die supraleitende Spule angefordert wurde. Dabei entsteht eine große Menge an Wärme, die durch eine entsprechende Kühlleistung einer Kühleinrichtung der Magnetresonanzeinrichtung 1 abzuführen ist. Diese Kühleinrichtung umfasst eine Kühlplatte 7, die nicht nur in einem thermischen Kontakt mit der Herunterfahrlasteinheit 4 steht, sondern auch an dieser befestigt ist, mithin von dieser getragen ist. Die Kühlplatte 7 weist der Übersichtlichkeit halber nicht dargestellte Kühlkanäle für ein über in Fig. 2 angedeutete Kühlleitungen 8 zuführbares Kühlmittel, hier Wasser, auf, das in einem Kühlmittelkreislauf der Kühleinrichtung zirkuliert.

An der Kühlplatte 7 ist nach außen hin, also auf der der Hauptmagneteinheit 2 abgewandten Seite, eine Trägerplatte 9 befestigt, die ebenso in wärmeleitendem Kontakt zu der Kühlplatte 7 steht, beispielsweise durch Verwendung eines wärmeleitenden Klebstoffs und/oder eines sonstigen wärmeleitenden Materials. Die Trägerplatte 9 ist deutlich größer als die Kühlplatte 7 ausgebildet und besteht vorliegend aus Aluminium.

Auf der Trägerplatte 9 sind wiederum neben der Leistungsversorgungseinheit 6 auch weitere Elektronikbaueinheiten 10 der Magnetresonanzeinrichtung 1, die gekühlt werden müssen, in wärmeleitendem Kontakt angebracht, vorliegend eine Sendeeinheit 11, eine Empfangseinheit 12 und eine Sequenzsteuereinheit 13.

Die Kühlplatte 9 kann in Fig. 1 nur angedeutete Strukturen 14, insbesondere Rippen- und/oder Dickevariationen aufweisen, um Wärmeführungswege von den Elektronikbaueinheiten 10 zu der Kühlplatte 7 zu definieren, welche eine unterschiedliche Wärmeleitfähigkeit in Abhängigkeit des Kühlbedarfs der jeweiligen Elektronikbaueinheit 10 aufweisen können.

Auf diese Weise wirkt die Trägerplatte 9 zum einen als Trägerteil für die Elektronikbaueinheiten 10, so dass mechanische Verbindungen an der Hauptmagneteinheit 2 vermieden werden, zum anderen aber auch als Wärmeverteiler beziehungsweise Kühlleistungsverteiler für die Elektronikbaueinheiten 10. Nachdem die Kühlplatte 7 ohnehin für die großen auftretenden Wärmemengen der Herunterlasteinheit dimensioniert ist, bestehen trotz des Zwischenschaltens der Trägerplatte 9 noch hinreichend hohe Kühlleistungen an den Elektronikbaueinheiten 10.

Die Kühleinrichtung kann zudem eine Kühlsteuereinheit (der Übersichtlichkeit halber nicht gezeigt, kann als weitere Elektronikbaueinheit 10 realisiert sein) aufweisen, die die über die Kühlplatte 7 bereitgestellte Kühlleistung steuern kann.

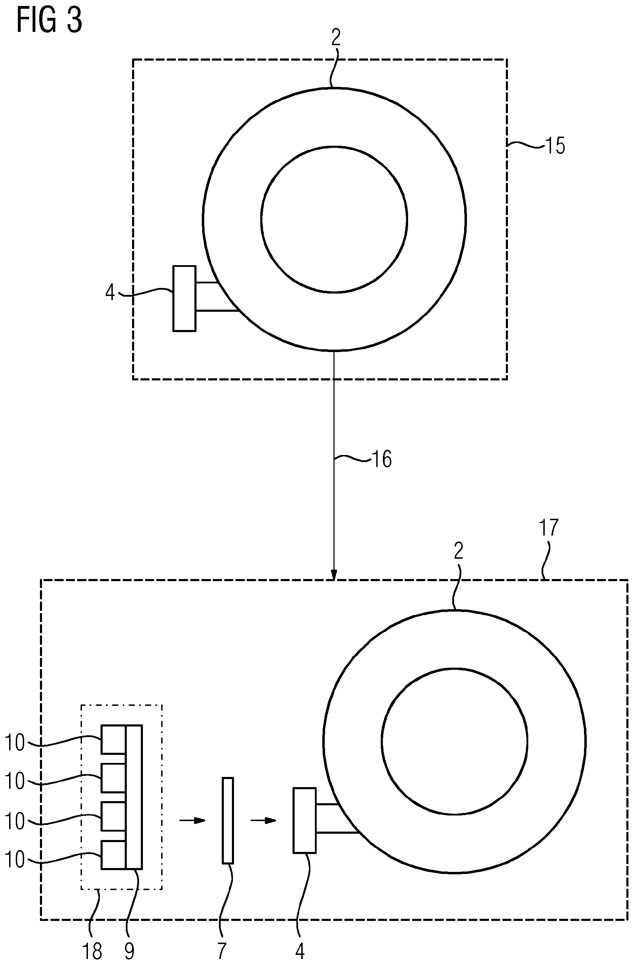

Fig. 3 erläutert schließlich ein erfindungsgemäßes Herstellungsverfahren einer solchen Magnetresonanzeinrichtung 1. An einem ersten Herstellungsort 15 wird die Hauptmagneteinheit 2 mit daran befestigter Herunterfahrlasteinheit 4 hergestellt und gemäß dem Pfeil 16 an einem zweiten Herstellungsort 17 geliefert. Dort wird zunächst die Kühlplatte 7 an der Herunterfahrlasteinheit 4 befestigt, wonach eine bereits vorgefertigte Baugruppe aus der Trägerplatte 9 und den Elektronikbaueinheiten 10 an der Kühlplatte 7 befestigt wird. Die Vorfertigung findet dabei insbesondere auch am zweiten Herstellungsort 17 statt, wie durch die Umrahmung 18 angedeutet wird.

Die Trägerplatte 9 kann an den Verlauf der Seitenfläche der Hauptmagneteinheit 2 angeformt sein, beispielsweise gekrümmt und/oder geknickt.

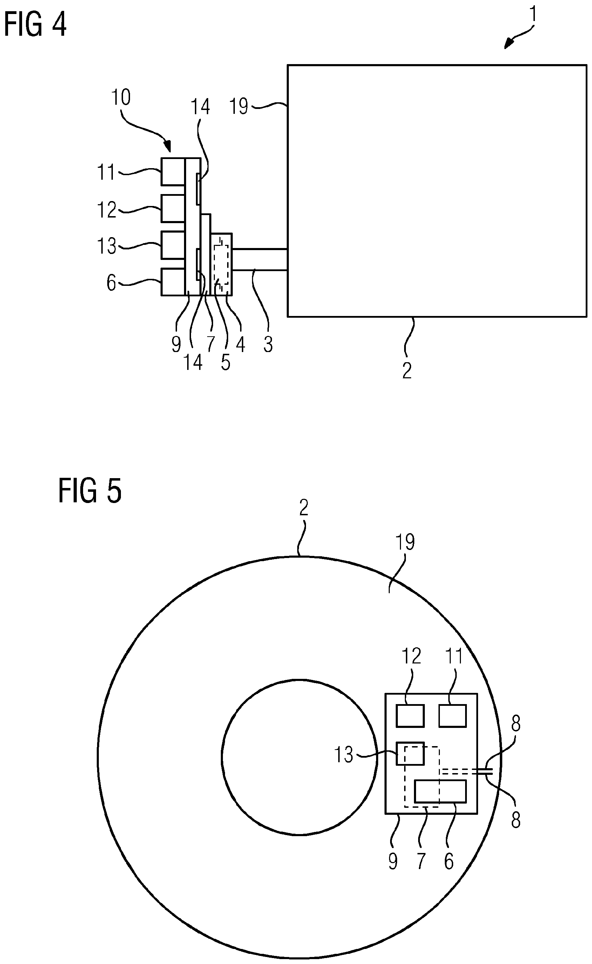

In einem in Fig. 4 und Fig. 5 entsprechend zu den Fig. 1 und Fig. 2 gezeigten zweiten Ausführungsbeispiel der Erfindung ist in bevorzugter Ausgestaltung die Rampkomponente, hier wiederum die Herunterfahrlasteinheit 4, an einer Stirnseite 19 der länglichen, hier wie auch im ersten Ausführungsbeispiel im Wesentlichen zylindrischen Hauptmagneteinheit 2 befestigt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welcher durch die Ansprüche gegeben ist.

## Patentansprüche

1. Magnetresonanzeinrichtung (1), aufweisend eine Hauptmagneteinheit (2) mit einem eine supraleitende Spule umfassenden Hauptmagneten zur Erzeugung eines Grundmagnetfelds, eine zum Herunterfahren und/oder zum Herauffahren des Hauptmagneten ausgebildete Rampvorrichtung mit einer an der Hauptmagneteinheit (2) angeordneten, bei einem Herauffahrvorgang und/oder einem Herunterfahrvorgang Wärme abgebenden Rampkomponente, eine Kühleinrichtung und wenigstens eine zu kühlende Elektronikbaueinheit (10), **dadurch gekennzeichnet, dass** die Kühleinrichtung eine mit der Rampkomponente in wärmeleitendem Kontakt stehende Kühlplatte (7) aufweist, wobei die Kühlplatte (7) an der Rampkomponente befestigt ist und an die Kühlplatte (7) auf der der Hauptmagneteinheit (2) abgewandten Seite in wärmeleitendem Kontakt eine Trägerplatte (9) anschließt, die wenigstens eine Elektronikbaueinheit (10) in wärmeleitendem Kontakt trägt.

2. Magnetresonanzeinrichtung (1) nach Anspruch 1, **dadurch gekennzeichnet, dass** die Rampkomponente eine Leistungsversorgungseinheit (6) für den Hauptmagneten und/oder eine an der Hauptmagneteinheit (2) angeordnete Herunterfahrlasteinheit (4) mit einer beim Herunterfahren genutzten elektrischen Last (5) ist.

3. Magnetresonanzeinrichtung (1) nach Anspruch 1 oder 2, **dadurch gekennzeichnet, dass** die Kühlplatte (7) mittels eines in der Kühleinrichtung zirkulierenden Kühlmittels, insbesondere von diesem durchströmt, kühlbar ist.

4. Magnetresonanzeinrichtung (1) nach einem der vorangehenden Ansprüche, **dadurch gekennzeichnet, dass** die Trägerplatte (9) größer als die Kühlplatte (7) ist.

5. Magnetresonanzeinrichtung (1) nach einem der vorangehenden Ansprüche, **dadurch gekennzeichnet, dass** die Trägerplatte (9), insbesondere über Befestigungsstutzen, an der Hauptmagneteinheit (2) befestigt ist und/oder dass die Kühlplatte (7) die an ihr befestigte Trägerplatte (9) mit der wenigstens einen Elektronikbaueinheit (10) trägt und/oder dass zumindest die Rampkomponente und/oder die Trägerplatte (9) an einer Stirnfläche (19) der länglichen und/oder im Wesentlichen zylindrischen Hauptmagneteinheit (2) befestigt ist.

6. Magnetresonanzeinrichtung (1) nach einem der vorangehenden Ansprüche, **dadurch gekennzeichnet, dass** die Trägerplatte (9) wenigstens eine wärmeführende Struktur (14), insbesondere eine Dickenveränderung und/oder wenigstens eine Kühlrippe, aufweist.

7. Magnetresonanzeinrichtung (1) nach Anspruch 6, **dadurch gekennzeichnet, dass** die wenigstens eine wärmeführende Struktur (14) einen Wärmeführungsweg von wenigstens einer der wenigstens einen Elektronikbaueinheit (10) zu der Kühlplatte (7) definiert.

8. Magnetresonanzeinrichtung (1) nach Anspruch 7, **dadurch gekennzeichnet, dass** für unterschiedliche Elektronikbaueinheiten (10) wenigstens teilweise eine unterschiedliche Wärmeleitfähigkeit aufweisende Wärmeführungswege in der Trägerplatte (9) vorgesehen sind, insbesondere in Abhängigkeit ihres Kühlbedarfs.

9. Magnetresonanzeinrichtung (1) nach einem der vorangehenden Ansprüche, **dadurch gekennzeichnet, dass** die wenigstens eine Elektronikbaueinheit (10) eine Sendeeinheit (11) und/oder eine Empfangseinheit (12) und/oder eine Sequenzsteuereinheit (13) und/oder, wenn von Anspruch 2 abhängig, die Leistungsversorgungseinheit (6) umfasst.

10. Magnetresonanzeinrichtung (1) nach einem der vorangehenden Ansprüche, **dadurch gekennzeichnet, dass** die Magnetresonanzeinrichtung zusätzlich eine die Kühleinrichtung steuernde Kühlsteuereinheit umfasst, welche zur Bereitstellung einer größeren Kühlleistung an die Kühlplatte (7) bei einem Herunterfahren und/oder Herauffahren des Hauptmagneten ausgebildet ist.

11. Verfahren zum Herstellen einer Magnetresonanzeinrichtung (1) nach einem der vorangehenden Ansprüche, umfassend folgende Schritte:
- an einem ersten Herstellungsort (15), Anbringen der insbesondere als Herunterfahrlasteinheit (4) ausgebildeten Rampkomponente an der Hauptmagneteinheit (2),
- an einem zweiten Herstellungsort (17), Anbringen der Kühlplatte (7) in wärmeleitendem Kontakt an der Rampkomponente, Anbringen der Trägerplatte (9) in wärmeleitendem Kontakt an der Kühlplatte (7), und Anbringen der wenigstens einen Elektronikbaueinheit (10) in wärmeleitendem Kontakt an der Trägerplatte (9).

12. Verfahren nach Anspruch 11, **dadurch gekennzeichnet, dass** an dem zweiten Herstellungsort zunächst die wenigstens eine Elektronikbaueinheit (10) in wärmeleitendem Kontakt an der Trägerplatte (9) angebracht wird, so dass eine vorgefertigte Baueinheit entsteht.

## Claims

1. Magnetic resonance device (1), having a main magnetic unit (2) with a main magnet comprising a superconducting coil for generating a basic magnetic field, a ramp device designed for running down and/or running up the main magnet, with a ramp component arranged on the main magnetic unit (2) emitting heat on a run-up process and/or a run down process, a cooling device and at least one electronic unit (10) to be cooled, **characterised in that** the cooling device has a cooling plate (7) which is in heat-conducting contact with the ramp component, wherein the cooling plate (7) is mounted on the ramp component and adjoining the cooling plate (7) on the side remote from the main magnetic unit (2) in heat-conducting contact is a carrier plate (9) which carries at least one electronic unit (10) in heat-conducting contact.

2. Magnetic resonance device (1) according to claim 1, **characterised in that** the ramp component is a power supply unit (6) for the main magnet and/or a run down load unit (4) arranged on the main magnetic unit (2) with an electrical load (5) used on running down.

3. Magnetic resonance device (1) according to claim 1 or 2, **characterised in that** the cooling plate (7) can be cooled by means of a coolant circulating in the cooling device, in particular coolant flows through it.

4. Magnetic resonance device (1) according to one of the preceding claims, **characterised in that** the carrier plate (9) is larger than the cooling plate (7).

5. Magnetic resonance device (1) according to one of the preceding claims, **characterised in that** the carrier plate (9), is mounted on the main magnetic unit (2), in particular by mounting brackets, and/or that the cooling plate (7) carries the carrier plate (9) mounted on it and having the at least one electronic unit (10) and/or that at least the ramp component and/or the carrier plate (9) is mounted on an end face (19) of the elongate and/or substantially cylindrical main magnetic unit (2).

6. Magnetic resonance device (1) according to one of the preceding claims, **characterised in that** the carrier plate (9) has at least one heat-conducting structure (14), in particular a change in thickness and/or at least one cooling rib.

7. Magnetic resonance device (1) according to claim 6, **characterised in that** the at least one heat-conducting structure (14) defines a heat-conducting path from at least one of the at least one electronic units (10) to the cooling plate (7).

8. Magnetic resonance device (1) according to claim 7, **characterised in that** for different electronic units (10), at least partially, heat-conducting paths having a different heat conductivity are provided in the carrier plate (9), in particular as a function of their cooling demand.

9. Magnetic resonance device (1) according to one of the preceding claims, **characterised in that** the at least one electronic unit (10) comprises a transmit unit (11) and/or a receive unit (12) and/or a sequence control unit (13) and/or, where dependent upon claim 2, the power supply unit (6).

10. Magnetic resonance device (1) according to one of the preceding claims, **characterised in that** the magnetic resonance device (1) additionally comprises a cooling control unit that controls the cooling device and is designed to supply a relatively high cooling capacity to the cooling plate (7) on running down and/or running up of the main magnet.

11. Method for producing a magnetic resonance device (1) according to one of the preceding claims, comprising the following steps:
- at a first place of production (15), attaching the ramp component, designed in particular as a run down load unit (4), to the main magnetic unit (2),
- at a second place of production (17), attaching the cooling plate (7) in heat-conducting contact to the ramp component, attaching the carrier plate (9) in heat-conducting contact to the cooling plate (7) and attaching the at least one electronic unit (10) in heat-conducting contact to the carrier plate (9).

12. Method according to claim 11, **characterised in that** at the second place of production, firstly the at least one electronic unit (10) is attached in heat-conducting contact to the carrier plate (9), so a prefabricated unit results.

## Revendications

1. Dispositif (1) de résonance magnétique, comportant une unité (2) d'aimant principal ayant un aimant principal comprenant une bobine supraconductrice pour la production d'un champ magnétique de base, un dispositif à rampe constitué pour déplacer vers le bas et/ou vers le haut l'aimant principal et ayant un composant de rampe, qui est monté sur l'unité (2) d'aimant principal et qui cède de la chaleur lors d'une opération de montée et/ou lors d'une opération de descente, un dispositif de refroidissement et au moins une unité (10) à refroidir de composant électronique,
**caractérisé en ce que** le dispositif de refroidissement a une plaque (7) de refroidissement en contact, d'une manière conductrice de la chaleur, avec le composant de rampe, dans lequel la plaque (7) de refroidissement est fixée au composant de rampe et à la plaque (7) de refroidissement et se raccorde, du côté non tourné vers l'unité (2) d'aimant principal, une plaque (9) de support en contact, de manière à conduire la chaleur, qui porte en contact, d'une manière conductrice de la chaleur, la au moins une unité (10) de composant électronique.

2. Dispositif (1) de résonance magnétique suivant la revendication 1, **caractérisé en ce que** le composant de rampe est une unité (6) d'alimentation en puissance de l'aimant principal et/ou une unité (4) de charge descendante, montée sur l'unité (2) d'aimant principale et ayant une charge (5) électrique utilisée lors de la descente.

3. Dispositif (1) de résonance magnétique suivant la revendication 1 ou 2, **caractérisé en ce que** la plaque (7) de refroidissement peut être refroidie, au moyen d'un fluide réfrigérant circulant dans le dispositif de refroidissement, en étant en particulier traversé par celui-ci.

4. Dispositif (1) de résonance magnétique suivant l'une des revendications précédentes, **caractérisé en ce que** la plaque (9) de support est plus grande que la plaque (7) de refroidissement.

5. Dispositif (1) de résonance magnétique suivant l'une des revendications précédentes, **caractérisé en ce que** la plaque (9) de support est fixée, en particulier par des appuis de fixation, à l'unité (2) d'aimant principal et/ou **en ce que** la plaque (7) de refroidissement porte la plaque (9) de support, qui lui est fixée, ayant la au moins une unité (10) de composant électronique et/ou **en ce que** au moins le composant de rampe et/ou la plaque (9) de support est fixé à une surface (19) frontale de l'unité (2) d'aimant principale oblongue et/ou sensiblement cylindrique.

6. Dispositif (1) de résonance magnétique suivant l'une des revendications précédentes, **caractérisé en ce que** la plaque (9) de support a au moins une structure (14) conduisant la chaleur, en particulier une modification d'épaisseur et/ou au moins une ailette de refroidissement.

7. Dispositif (1) de résonance magnétique suivant la revendication 6, **caractérisé en ce que** la au moins une structure (14) conduisant la chaleur définit un chemin de conduite de la chaleur d'au moins l'une de la au moins une unité (10) de composant électronique à la plaque (7) de refroidissement.

8. Dispositif (1) de résonance magnétique suivant la revendication 7, **caractérisé en ce que** pour des unités (10) de composant électronique différentes, il est prévu des chemins de conduite de la chaleur, ayant une conductibilité de la chaleur différente, dans la plaque (9) de support, en particulier en fonction de son besoin de refroidissement.

9. Dispositif (1) de résonance magnétique suivant l'une des revendications précédentes, **caractérisé en ce que** la au moins une unité (10) de composant électronique comprend une unité (11) d'émission et/ou une unité (12) de réception et/ou une unité (13) de commande de séquence et/ou lorsqu'elles dépendent de la revendication 2, l'unité (6) d'alimentation de puissance.

10. Dispositif (1) de résonance magnétique suivant l'une des revendications précédentes, **caractérisé en ce que** le dispositif de résonance magnétique comprend en outre une unité de commande de refroidissement commandant le dispositif de refroidissement, qui est constituée pour disposer d'une puissance de refroidissement plus grande sur la plaque (7) de refroidissement lors de la descente et/ou de la montée de l'aimant principal.

11. Procédé de fabrication d'un dispositif (1) de résonance magnétique suivant l'une des revendications précédentes, comprenant les stades suivants :
- en un premier emplacement (15) de fabrication, montage sur l'unité (2) d'aimant principal du composant de rampe, constitué en particulier comme unité (4) de charge se déplaçant vers le bas,
- en un deuxième emplacement (17) de fabrication, montage de la plaque (7) de refroidissement en contact, de manière à conduire la chaleur, avec le composant de rampe,
montage de la plaque (9) de support en contact, de manière à conduire la chaleur, avec la plaque (7) de refroidissement et montage de la au moins une unité (10) de composant électronique en contact, de manière à conduire la chaleur, avec la plaque (9) de support.

12. Procédé suivant la revendication 11, **caractérisé en ce qu'**au deuxième emplacement de fabrication, on monte d'abord la au moins une unité (10) de composant électronique en contact, de manière à conduire la chaleur, avec la plaque (9) de support, de manière à créer une unité de construction préfabriquée.
